# EUROPEAN PATENT SPECIFICATION

(11) **EP 1 563 550 B1**
(45) Date of publication and mention of the grant of the patent: **14.01.2009**
(21) Application number: 03775517.0
(22) Date of filing: 11.11.2003
(51) Int. Cl.: H01L 41/09, H04R 17/00

(54) **ELECTRO-ACTIVE ACTUATOR**
ELEKTROAKTIVER AKTUATOR
ACTIONNEUR ELECTRO-ACTIF

(30) Priority: 19.11.2002 GB 0226846; 24.12.2002 GB 0229927; 28.03.2003 GB 0307160; 21.05.2003 GB 0311676
(43) Date of publication of application: 17.08.2005
(73) Proprietor: 1... Limited, Cambridge CB4 0WS (GB)
(72) Inventor: ALLAN, James, Risby, Bury St. Edmonds, Suffolk IP28 6QU (GB); PEARCE, David, Henry, Moseley, Birmingham B13 9PT (GB); TOPLISS, Richard, Trumpington, Cambridge CB2 2NQ (GB)
(74) Representative: Merryweather, Colin Henry
(86) International application number: PCT/GB2003/004862
(87) International publication number: WO 2004/047192

(56) References cited:
- WO-A-01/47041
- WO-A-02/103451
- US-A- 3 816 774
- US-A- 4 633 122
- US-A1- 2002 067 841
- PATENT ABSTRACTS OF JAPAN vol. 1997, no. 10, 31 October 1997 (1997-10-31) -& JP 09 148643 A (SONY CORP), 6 June 1997 (1997-06-06)

## Description

This invention relates to electro-active actuators. More particularly, it relates to elements of electro-active material comprising curved and non-curved (flat) portions.

Electro-active materials are materials that deform or change their dimensions in response to applied electrical conditions or, *vice versa,* have electrical properties that change in response to applied mechanical forces. The best-known and most used type of electro-active material is piezoelectric material, but other types of electro-active material include electrostrictive material.

Many devices that make use of electro-active materials are known. The simplest piezoelectric device is a block of pre-poled, i.e., pre-oriented, piezoelectric material activated in an expansion-contraction mode by applying an activation voltage in direction of the poling.

Electro-active effects are extremely small, e.g. in the order of 1 nm/V, so that the change in dimensions is relatively small and requires high voltages. Therefore, more complicated electro-active structures, such as stacks, unimorph or bimorph benders, recurved benders, corrugated benders, spiral or helical designs, have been developed to achieve larger displacements.

Benders, stacks, tubes and other electro-active actuators are employed in a wide array of engineering systems, ranging from micro-positioning applications and acoustic wave processing to printing applications. Generally, actuators are used in such applications to generate force and effect displacement, for example, to move levers or other force transmitting devices, pistons or diaphragms, to accurately position components, or to enable similar system functions. Actuators employed for such functions are typically designed to provide a desired displacement or stroke over which a desired force is delivered to a given load.

Depending upon design, electro-active actuators can generate rotational or translational displacements or combinations of both movements. Curved actuators capable of such displacements are known.

A curved actuator in the form of a flat ceramic bender curved into an almost tubular shape is described in the commonly-owned published international patent application WO-03/001841. The curved actuator forms part of a loudspeaker, in which the actuator is mounted on a support and coupled to an area-extensive section of the case of the device, which section of the case acts as the sound generating element of the loudspeaker. In embodiments illustrated therein the actuator acts upon an edge of the sound generating element, the rotational displacement of the actuator being transmitted to rotational displacement of the sound generating element through the coupling. In cross-section, the actuator appears as a portion of a circle or the shape of a letter C.

Other curved actuators capable of comparably large translation displacements are described in the commonly-owned published international patent application WO-01/47041 and by D. H. Pearce et al in: Sensors and Actuators A 100 (2002), 281-286. These actuators are helical structures of coiled piezoelectric bender tape. Such twice-coiled or "super-helical" devices are found to easily exhibit displacement in the order of millimetres on an active length of the order of centimetres. The two-part form of claim 1 is based on WO-01/47041.

According to a first aspect of the present invention, there is provided an electro-active actuator having a continuous electro-active member extending along a minor axis which is curved, the continuous electro-active member curving around the minor axis and arranged with electrodes to bend, on activation, around the minor axis, thereby to twist around the minor axis concomitantly with relative displacement of portions of the actuator out of the plane of the curve of the minor axis, characterised in that the minor axis follows a curve consisting of two sections of opposite curvature with a single change in curvature at the point between the two sections and with rotational symmetry about the point between the two sections.

This type of actuator is hereinafter referred to the S-type, although merely for ease of reference and without implying any limitation as regards the shape of the actuator.

According to a second aspect of the present invention, there is provided an electro-active actuator adapted to move objects in a straight line, said actuator consisting of two actuator sections coupled by a joint element, each of said actuator sections having a continuous electro-active member extending along a minor axis which is curved, the continuous electro-active member curving around the minor axis and arranged with electrodes to bend, on activation, around the minor axis, thereby to twist around the minor axis concomitantly with relative displacement of the ends of the actuator out of the plane of the curve of the minor axis, said actuator sections being arranged with rotational symmetry about said joint element.

According to both aspects of the invention, the actuator has two sections, each comprising a continuous electro-active member extending along a minor axis which is itself curved. The member curves around the minor axis and is arranged with electrodes to bend around the minor axis, thereby to twist around the minor axis concomitantly with relative displacement out of the place of the curve of the minor axis. Thus each section is equivalent to the type of device disclosed in WO-01/47041. However an actuator according to the present invention includes at least two curved sections, being sections of the same continuous member or being different sections coupled by a joint element at which the curvature of the minor axis changes from inward bowing (concave) to outward bowing (convex). In a more mathematical description, the curvature of the minor axis changes its sign when applying the right hand rule to determine the orientation of the curvature along the minor axis from one end of the device to the other.

By virtue of the rotational symmetry, deviations from a straight linear motion of moving ends of the device balance each other out, and so cancel each other. To do this effectively the sections may be substantially identical and driven by substantially identical control signals or voltages. Substantially identical means the devices have the displacement versus applied voltage properties so as to not hamper each other's straight-line motion but being capable of balancing out other components of the displacement, notwithstanding immaterial differences or inadvertent variations due to manufacturing tolerances or the like.

According to the first aspect the two curved sections are formed from a single continuous member. In a variant of this, the joint section is a small portion of the tape and the device has thus the form of the letter "S".

According to the second aspect, a joint element provides connection points to two actuator sections.

By making the joint element flexible in the desired direction of motion but stiff in other directions, the maximum useable linear displacement of the jointed two sections may be increased.

The present invention is particularly advantageous for use as loudspeaker drive unit or lens drive system.

These and other aspects of inventions will be apparent from the following detailed description of non-limitative examples making reference to the following drawings, in which:
Fig. 1 is a perspective view of a twice-coiled actuator as known;
Fig. 2 shows an example of an actuator of the S-type in accordance with the present invention;
Fig. 3 shows a schematic cross-sectional view showing the flat end portion of the actuator of Fig. 2 and illustrating the bender construction;
Fig. 4 shows the example of Fig. 2 as drive unit for a center-mounted loudspeaker cone;
Figs. 5A, 5B shows a further example of an S-type actuator in accordance with the present invention; and
Fig. 6 shows another example of an S-type actuator in accordance with the present invention.

In the hereinafter described embodiments, the described shapes of the various actuators are the normal, permanent shape in the inactive state.

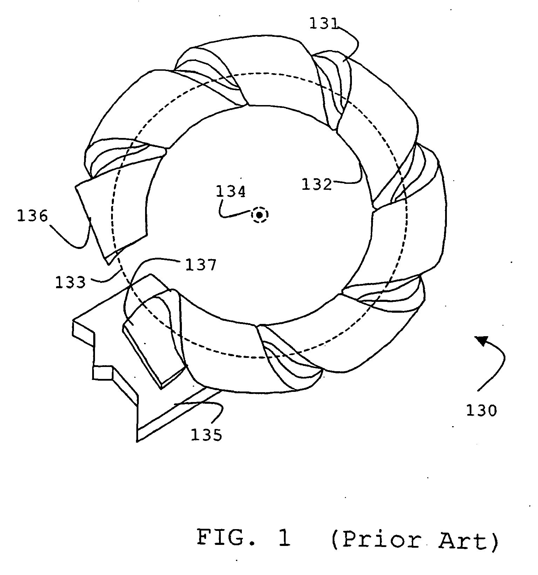

A known actuator 130 of the type described in the above-mentioned WO-01/47041 and Sensors and Actuators A 100 (2002), 281 -286 is shown in Fig. 1. As previously discussed, the known actuator 130 comprises an electro-active member 132 having a bender construction, eg a bimorph tape 131, that extends along and is curved helically around an axis 133 referred to as the minor axis 133. The minor axis 133 is nominal and for illustration is shown as a dashed line in Fig. 1. The minor axis 133 is curved, for example along a section of a circle in Fig. 1. The electro-active member 132 is arranged to bend, on activation, around the minor axis 133 and hence to twist around the minor axis 133 concomitantly.

The minor axis is itself curved, for example in Fig. 1 along a section of a circle amounting to about three quarters of a complete turn. The axis 134 of this secondary curve is referred to as the major axis 134and shown as a small dashed circle with a central solid point again to facilitate description and illustration. The curve around the minor axis 133 may be referred to as the primary winding or primary helix. The curve around the major axis 134 may be referred to as the secondary winding, and could exceed one turn and form a spiral or secondary helix.

As a result of the curve around the major axis 134, the twisting on activation described just above is concomitant with relative displacement of the two ends 136 and 137 of the electro-active member 132 out of the plane of the curve. In particular, the distal free end 136 moves parallel to the major axis 134 and thus perpendicular to the paper plane assuming that the base-mounted or near end 137 is fixed to an immobile support 135.

As the displacement of the distal end 136 represents a motion caused by summing infinitesimal rotational and bending displacements of the tape 131 around the minor axis 133, it is not surprising that its motion is not strictly linear in the sense of moving in a straight line but comprises small rotational components and unwanted (off-axis) translational. These deviations from a straight line are acceptable in many applications and can be limited by further mechanical constraints such as bearings.

Embodiments of the S-type will now be described. These embodiments improve the straight-line motion of the known actuator 130 of Fig. 1 by coupling one or more of the known actuators as balanced pairs, of essentially identical actuator sections into a configuration arranged such that at least some of the non-linearities of the known actuator are balanced out and hence reduced or eliminated from the motion of the free end of the combined actuator.

As the piezo-ceramic tape undergoes many manufacturing steps from the formulation of the base powder including tape casting, electroding, winding, firing and poling, all of which could potentially introduce variations and inhomogeneity between single actuators, it is advantageous to manufacture the balanced sets of actuator sections from a single continuous tape. Thus in a first example of an actuator in accordance with the present invention, a balanced pair is formed from a continuous tape of electro-active ceramic material.

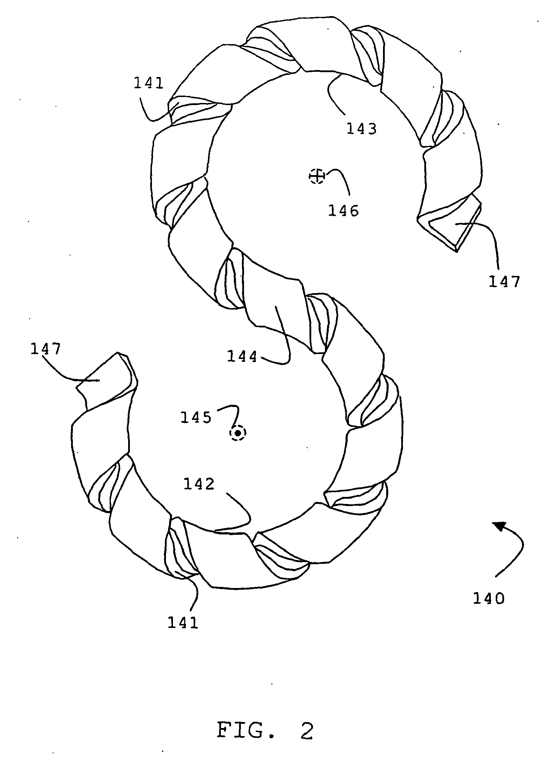

An actuator 140 of the S-type 140 of Fig. 2 comprises an electro-active member 141 having a bender construction, eg a bimorph tape, that extends along and is curved helically around a minor axis which is curved to have two sections 142, 143. In each section 142, 143, the minor axis has opposite curvature such that there is rotational symmetry about the point between the two sections 142, 143. Thus, the sections 142, 143 are coupled by a small joint section 144 which is a portion of the electro-active member at which the curvature changes. Each section 142, 143 extends substantially along a section of a circle. This is preferred as being the best shape for balanced operation, as described in more detail below, although other curves would be sufficient. Each section 142, 143 has the same construction as the known actuator 130 described above except that the electro-active member 141 is continuous between the two sections 142, 143. In general, any of the features of the construction and/or arrangement of any of the actuators formed from a continuous member which are described and claimed in WO-01/47041 and Sensors and Actuators A 100 (2002), 281-286, could be applied to the sections 142, 143 of the electro-active member.

Both sections 142, 143 include a curved portion of bimorph tape 141 that is wound helically around a first axis that is referred to as minor axis. The helically wound portion is further coiled into a secondary winding of about two-thirds of a complete turn.

However, the first section 142 is bent inwardly thus giving the first section concave curvature. In the joint section 144 the curvature is reduced and approaches zero before the minor axis bends outwardly in the part of the helically wound tape that forms the second section 143 of the actuator.

The device of Fig. 2 exhibits a symmetry about the joint section that could be described as being point-symmetric. It is therefore arbitrary to define the first section as concave and the second section as convex. It is however important to notice that the curvature changes its sign or orientation from one section to the other. A sign or orientation can be assigned to a curvature by use of the so-called right hand rule, following which, as the fingers are curled as the device, the thumb defines its orientation. Applying this rule at each point of the device from one end to the other the orientation flips after passing through the joint section. The major axes 145, 146 of the first and second sections 142, 143, respectively, are illustrated in Fig. 2, with a point in a dashed circle marking an orientation out of the paper plane and cross in a dashed circle marking the opposite orientation.

The number of primary windings is six for each section of the actuator. The thickness of the tape is 1.2 mm. Its width is 5.5 mm. The outer diameter of the primary helix is 5 mm and the outer diameter of the secondary helix, which is a 0.75 turn, is 30 mm. Each section includes an additional half turn that makes up the joint section 144 of the actuator. The tape has a linear piezo constant of 135 pC/N. Such a bimorph tape device can be driven by a 600 Volt amplitude signal to a maximal displacement of 0.5 mm. In a device with 8 active layers of piezoelectric material the same displacement can be achieved with a drive voltage of 150 V.

The flat plateau part of the joint section 144 is located at a circumferentially opposite position (with regard to the circumference of the minor helix) to the end parts of both the first and second section. In addition, at the end of the single curved portion constituted by the two sections 142, 143, the electro-active element 140 extends continuously into two flat portions 147.

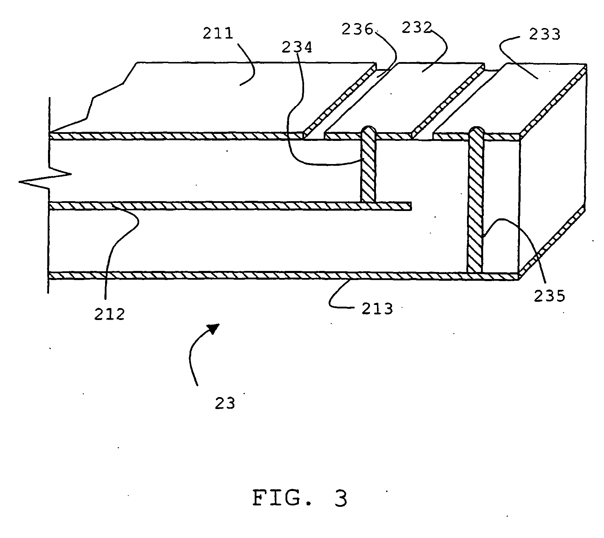

The electro-active member 141 has a bender construction extending continuously along the the curved portion constituted by the two sections 142, 143 and the two flat portions 147. The bender construction may be arranged as shown in Fig. 3 which is a cross-sectional view of a terminal portion 23 corresponding to one of the flat portions 147 and having an arrangement of terminals for electrical connection to the electrode layers shown in Fig. 3.

The construction of the terminal portion 23 distal from the end, that is shown on the left hand side of Fig. 3, is a bender construction comprising two layers of electro-active material, preferably piezoelectric material. The hatched portions are electrically conductive and comprise the electrode layers 211, 212, 213 arranged to pole and activate the actuator. This bender construction extends continuously into and along the curved portion 12 of the actuator 13 and provides the bending of the curved portion described above. The bender construction also causes some bending of the terminal portion 23, although the degree of the resulting displacement is relatively small as the length of the terminal portion 23 is significantly less than the length of the curved portion 12, by at least an order of magnitude.

At the end of the terminal portion 23, that is shown on the right hand side of Fig. 3, the terminal portion 23 has, on the same surface 236 as a first outer electrode layer 211, two terminals 232, 233 isolated from each other and from the first outer electrode layer 211. Electrically conductive paths 234, 235 extending through openings punched or drilled through the terminal connect the two terminals 232, 233 to the inner electrode 212 and the second outer electrode 213, respectively. As a result, electrical connection to all the electrodes 211, 212, 213 of the actuator 11 can be made by contact on a single face 236 of the terminal 23.

This arrangement of the joint section 144 and the flat portions 147 facilitates the mounting of objects to be driven or actuated by the actuator 140.

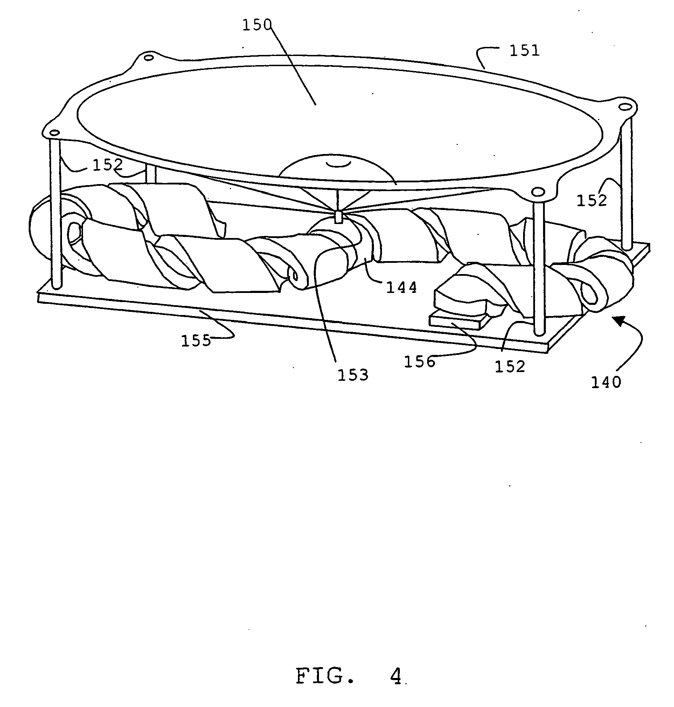

As a result of the curvature of the electro-active member 141, the twisting of the sections 142, 143 which occurs on activation is concomitant with relative displacement of the joint section 144 with respect to the opposite end portions 147 of the two curved sections 142, 143. In use the end portions 147 are coupled to one object and the joint section 144 is coupled to another object to drive relative displacement of the two objects, as for example in the following arrangement shown in Fig. 4 which illustrates a loudspeaker configuration.

In Fig. 4, the actuator 140 of Fig. 2 is shown driving an oval shaped cone 150. The cone is the sound-generating element or the diaphragm of a loudspeaker system. The flange 151 of the cone is connected to the mounting plate 155 of the actuator through four struts 152. The actuator 140 rests on two flat mounting posts 156 (only one is shown) above the mounting plate 155. At its centre, the joint section 144 and the apex 153 of the cone 150 are connected. Alternatively, the mounting points could be reversed, using the central joint section to mount the actuator onto the immobile base and connecting the object to be moved to one or both ends of the actuator.

In operation, the device of Fig. 4 is driven with a drive voltage of up to +/-600 V peak voltage modulated with frequencies within the acoustic frequency range of 20 Hz to 20 kHz.

The actuators of Figs. 2 or 4 can be made using the manufacturing steps known for producing super-helical devices (as shown in Fig. 1), for example as follows.

A difficulty to be overcome when producing curved ceramic structures with projecting tabs lies in the plasticity of the green tape used as an intermediate in the manufacturing process of complex ceramic actuators.

To fabricate the actuators, a commercial piezoelectric lead zirconate titanate (PZT) powder can be used as the strating material, for example TRS 600 (TRS Ceramics Penn., USA). The powder is mixed with polyvinyl butyral binder and cyclohexanone on a twin-roll mill until a uniform 1 mm thick sheet is obtained. This material is then rolled up and extruded to obtain a uniformly thick and defect-free sheet. The sheet is then calendered to the required thickness being half that of the final bimorph tape. The bimorph structure is produced by screen printing the tape with conductive ink such as platinum ink. Two or more of these tapes can then be laminated to form bimorphs. Strips of suitable width are cut from the tape and wound on to a first cylindrical former the outer diameter of which determines the inner diameter of the primary helix. The strips are then placed into a second former that determines the secondary helix radius.

The second former has a shallow groove or a narrow cut into which the end of the laminated strip is placed. The dimensions and orientation of the shallow groove or narrow cut, together with the length of the ceramic strip placed into it, determine the orientation and length of the final terminal tab.

The assembled structure is then dried to remove solvents and plastizers. At this stage support for the projecting terminal may not be necessary as the structure becomes sufficiently rigid to not collapse under its own weight. The actuator is then fired. Following a slow binder removal stage at up to 600 degrees C, the material is sintered at 1200 degrees C for 1 hour.

Soldered electrode contacts are made to the outer two electrodes and the single inner electrode. The material is poled in a heated silicone oil bath at 120 degrees C and 2.5kVmm-1 for 10 minutes. After cleaning, the outer two electrodes are joined together to form a single external electrode which, together with the central electrode, is used to generate the required opposing actuation fields.

For S-type actuators, the second former has an S-shaped groove having a depth in the order of the diameter of the primary helix.

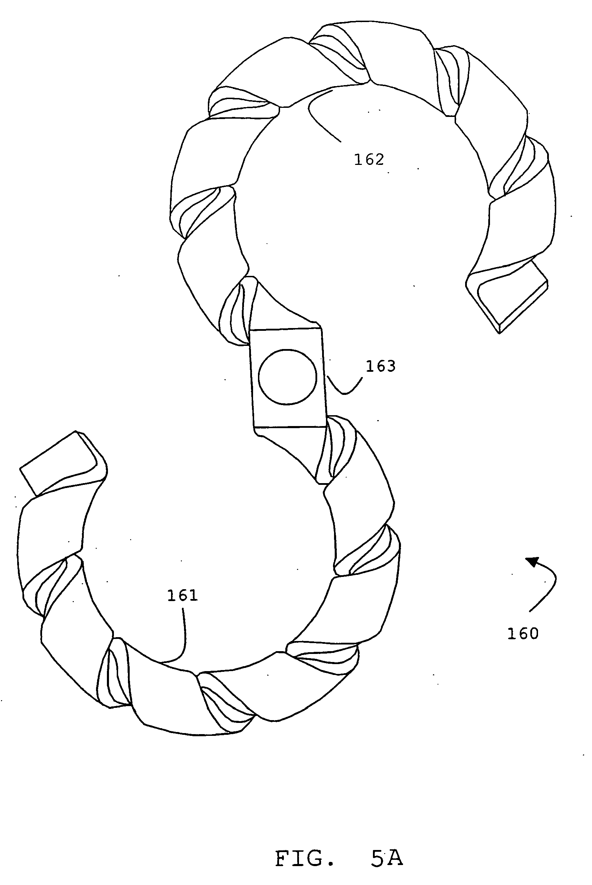

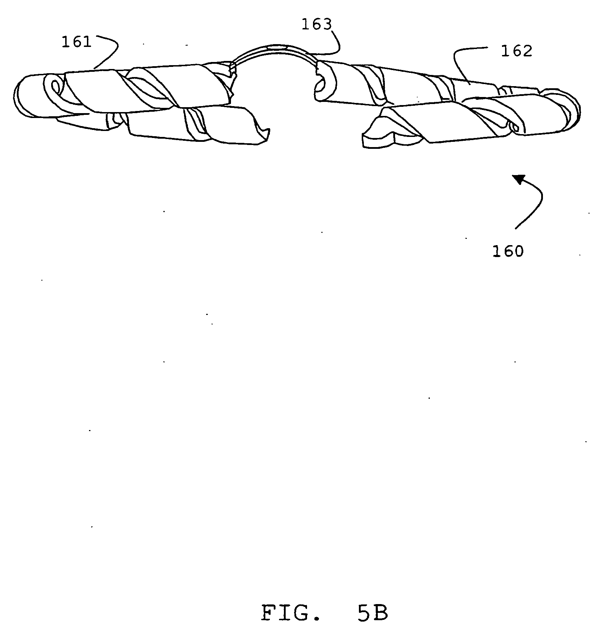

In other examples of the invention the novel actuator 160 is assembled by joining two actuators as known per se and illustrated in Fig. 1 through a joint element or hub of hetero (non-piezoelectric) material such as metal or plastics. In Fig. 5, the joint element is a steel flexure 163. The flexure is designed to be stiff in lateral directions while being more flexible in the vertical (out of the paper plane of Fig. 5A). The actuator further includes two three-quarter turn super-helical actuators 161, 162 bonded at their respective distal ends by a glue or adhesive or other suitable attaching technique to the joint element 163.

In this configuration the actuator can exhibit a larger displacement with albeit less force than the example described above.

In Fig. 5B the device 160 is shown with both actuator sections 161, 162 bent upwards. The displacement causes the joint element 163 to flex. In applications where such a flexing action is not desired, the flexure could be replaced with a stiff bridge element with or without hinges at the joining lines with the two actuators, or with a single hinge at the center of the joining piece.

The configuration of Fig. 5 can be extended to multi-turn sections where each actuator section has several turns around its major axis before being joined.

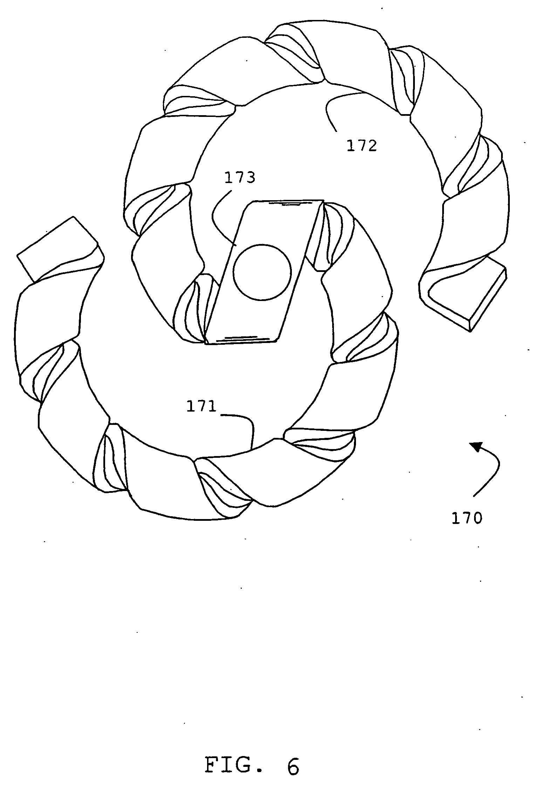

Alternatively, the two actuator sections may be nested. In Fig. 6 the free ends of each section 171, 172 are located within the inner circumference of the other section, thus providing a more compact configuration of the novel actuator. The elements and structures in Fig. 6 are otherwise identical to those of Fig. 5 and are, hence, not further described.

## Claims

1. An electro-active actuator (140) having a continuous electro-active member (141) extending along a minor axis which is curved, the continuous electro-active member (141) curving around the minor axis and arranged with electrodes to bend, on activation, around the minor axis, thereby to twist around the minor axis concomitantly with relative displacement of portions of the actuator out of the plane of the curve of the minor axis, **characterised in that** the minor axis follows a curve consisting of two sections (142, 143) of opposite curvature with a single change in curvature at the point between the two sections (142, 143) and with rotational symmetry about the point between the two sections (142, 143).

2. The electro-active actuator of claim 1, wherein the continuous electro-active member (141) curves around the minor axis in a helix.

3. The electro-active actuator of claim 1 or 2, wherein the actuator (140) is mounted to a first object at said point between the two sections (142, 143) and to a second object at the opposite ends of said two sections (142, 143).

4. The electro-active actuator of any one of claims 1 to 3, wherein said two sections (142, 143) of opposite curvature are substantially sections of a circle.

5. An electro-active actuator (160) adapted to move objects in a straight line, said actuator consisting of two actuator sections (161, 162) coupled by a joint element (163), each of said actuator sections (161, 162) having a continuous electro-active member extending along a minor axis which is curved, the continuous electro-active member curving around the minor axis and arranged with electrodes to bend, on activation, around the minor axis, thereby to twist around the minor axis concomitantly with relative displacement of the ends of the actuator (160) out of the plane of the curve of the minor axis, said actuator sections (161, 162) being arranged with rotational symmetry about said joint element (163).

6. The electro-active actuator of claim 5, wherein the actuator sections (161, 162) are substantially identical.

7. The electro-active actuator of claim 5 or 6, wherein the continuous electro-active element curves in a helix around the minor axis.

8. The electro-active actuator of any one of claims 5 to 7, wherein the joint element (163) comprises a material which is not piezoelectric material.

9. The electro-active actuator of any one of claims 5 to 8, wherein the joint element (163) is adapted to be less stiff in one direction than in the other directions.

## Patentansprüche

1. Elektroaktiver Aktuator (140) mit einem durchgehenden elektroaktiven Element (141), das sich entlang einer Nebenachse die gekrümmt ist erstreckt, wobei das durchgehende elektroaktive Element (141) um die Nebenachse gekrümmt und mit Elektrode angeordnet ist, um bei einer Aktivierung um die Nebenachse zu verbiegen, um **dadurch** einhergehend mit einer relativen Versetzung von Bereichen des Aktuators aus der Ebene der Krümmung der Nebenachse heraus um die Nebenachse zu verdrehen, **dadurch gekennzeichnet, dass** die Nebenachse einer Krümmung folgt, die zwei Abschnitte (142, 143) mit entgegengesetzter Krümmung aufweist, mit einer einzigen Änderung der Krümmung an dem Punkt zwischen den zwei Abschnitten (142, 143), und mit einer Rotationssymmetrie um den Punkt zwischen den zwei Abschnitten (142, 143).

2. Elektroaktiver Aktuator nach Anspruch 1, wobei das durchgehende elektroaktive Element (141) sich um die Nebenachse in einer Helix krümmt.

3. Elektroaktiver Aktuator nach Anspruch 1 oder 2, wobei der Aktuator (140) an einem ersten Objekt an dem Punkt zwischen den zwei Abschnitten (142, 143) und an einem zweiten Objekt an gegenüberliegenden Enden der zwei Abschnitte (142, 143) montiert ist.

4. Elektroaktiver Aktuator nach einem der Ansprüche 1 bis 3, wobei die zwei Abschnitte (142, 143) von entgegen gesetzter Krümmung im Wesentlichen Abschnitte eines Kreises sind.

5. Elektroaktiver Aktuator (160), der angepasst ist zum Bewegen von Objekten in einer geraden Linie, wobei der Aktuator aus zwei Aktuatorabschnitten (161, 162) besteht, die durch ein Verbindungselement (163) gekoppelt sind, wobei jeder der Aktuatorabschnitte (161, 162) ein durchgehendes elektroaktives Element aufweist, das sich entlang einer Nebenachse, die gekrümmt ist, erstreckt, wobei das kontinuierliche elektroaktive Element sich um die Nebenachse krümmt und mit Elektroden angeordnet ist, um bei einer Aktivierung um die Nebenachse herum zu biegen, um **dadurch** um die Nebenachse zu verdrehen, einhergehend mit einer relativen Versetzung der Enden des Aktuators (160) aus der Ebene der Krümmung der Nebenachse heraus, wobei die Aktuatorabschnitte (161, 162) mit einer Rotationssymmetrie um das Verbindungselement (163) herum angeordnet sind.

6. Elektroaktiver Aktuator nach Anspruch 1, wobei die Aktuatorabschnitte (161, 162) im Wesentlichen identisch sind.

7. Elektroaktiver Aktuator nach Anspruch 5 oder 6, wobei das durchgehende elektroaktive Element in einer Helix um die Nebenachse herum gekrümmt ist.

8. Elektroaktiver Aktuator nach einem der Ansprüche 5 bis 7, wobei das Verbindungselement (163) ein Material aufweist, das kein piezoelektrisches Material ist.

9. Elektroaktiver Aktuator nach einem der Ansprüche 5 bis 8, wobei das Verbindungselement (163) angepasst ist um in einer Richtung weniger steif zu sein als in den anderen Richtungen.

## Revendications

1. Actionneur électro-actif (140) comportant un élément électro-actif continu (141) s'étendant le long d'un petit axe qui est courbé, l'élément électro-actif continu (141) étant courbé autour du petit axe et muni d'électrodes pour s'incurver, lors de l'activation, autour du petit axe, afin de se tordre autour du petit axe simultanément à un déplacement relatif des parties de l'actionneur hors du plan de la courbe du petit axe, **caractérisé en ce que** le petit axe suit une courbe constituée de deux portions (142, 143) de courbure contraire avec un seul changement de courbure au point situé entre les deux portions (142, 143) et avec une symétrie de rotation autour du point situé entre les deux portions (142, 143).

2. Actionneur électro-actif selon la revendication 1, dans lequel l'élément électro-actif continu (141) s'enroule en hélice autour du petit axe.

3. Actionneur électro-actif selon la revendication 1 ou 2, dans lequel l'actionneur (140) est monté sur un premier objet au niveau dudit point situé entre les deux portions (142, 143) et sur un deuxième objet au niveau des extrémités opposées desdites deux portions (142, 143).

4. Actionneur électro-actif selon l'une quelconque des revendications 1 à 3, dans lequel lesdites deux portions (142, 143) de courbure contraire sont substantiellement des sections d'un cercle.

5. Actionneur électro-actif (140) adapté pour déplacer des objets en ligne droite, ledit actionneur étant constitué de deux parties d'actionneur (161, 162) couplées par un élément de jonction (163), chacune desdites parties d'actionneur (161, 162) comportant un élément électro-actif continu s'étendant le long d'un petit axe qui est courbé, l'élément électro-actif continu étant courbé autour du petit axe et muni d'électrodes pour s'incurver, lors de l'activation, autour du petit axe, afin de se tordre autour du petit axe simultanément à un déplacement relatif des parties de l'actionneur (160) hors du plan de la courbe du petit axe, lesdites parties d'actionneur (161, 162) étant pourvues d'une symétrie de rotation autour dudit élément de jonction (163).

6. Actionneur électro-actif selon la revendication 5, dans lequel les parties d'actionneur (161, 162) sont sensiblement identiques.

7. Actionneur électro-actif selon la revendication 5 ou 6, dans lequel l'élément électro-actif continu s'enroule en hélice autour du petit axe.

8. Actionneur électro-actif selon l'une quelconque des revendications 5 à 7, dans lequel l'élément de jonction (163) comprend un matériau qui n'est pas un matériau piézoélectrique.

9. Actionneur électro-actif selon l'une quelconque des revendications 5 à 8, dans lequel l'élément de jonction (163) est adapté pour être moins rigide dans une direction que dans les autres directions.
